# EUROPÄISCHE PATENTANMELDUNG

(11) **EP 2 835 876 A1**
(43) Veröffentlichungstag der Anmeldung: **11.02.2015**
(21) Anmeldenummer: 13464009.3
(22) Anmeldetag: 05.08.2013
(51) Int. Cl.: H01R 13/508, H01R 13/52, H01R 13/66, B60R 16/023, H05K 5/00

(54) **Modulgehäuse für elektronische Baugruppe**

(71) Anmelder: Continental Automotive GmbH, 30165 Hannover (DE)
(72) Erfinder: Sorin, Andrei, 300566 Timisoara (RO); Bagung, Detlev, 93170 Bernhardswald (DE); Chastanet, Jérome, 31400 Toulouse (FR); Drew, Gregory, 93051 Regensburg (DE); Roller, Bernd, 93055 Regensburg (DE)

(57) **Zusammenfassung**

Es wird ein Modulgehäuse mit einem Gehäusebauteil (100) zur Befestigung einer elektronischen Baugruppe und einem Steckverbinder (200) zur elektrischen Verbindung mit der Baugruppe angegeben. Der Steckverbinder (200) hat einen Grundkörper (201) mit einer Vielzahl von Aufnahmen (215) für elektrische Steckkontakte (217) und einen die Aufnahmen (215) umlaufenden Steckrahmen (220). Das Modulgehäuse weist zur mechanischen Befestigung des Steckverbinders (200) am Gehäusebauteil (100) eine Arretierungsanordnung auf, die ein Arretierungselement (205) des Steckverbinders (200) und ein Arretierungselement (102) des Gehäusebauteils (100) aufweist, wobei das Arretierungselement ein Hakenelement (210) und das Arretierungselement (102) des Gehäusebauteils (100) eine korrespondierende Aussparung (105) zur Aufnahme des Hakenelements (210) aufweist.

## Beschreibung

Die Erfindung betrifft ein Modulgehäuse. Insbesondere betrifft die Erfindung ein Modulgehäuse zur Aufnahme einer elektronischen Steuereinrichtung zum Einsatz in einem Kraftfahrzeug.

Ein Modulgehäuse ist dazu eingerichtet, eine elektronische Schaltung aufzunehmen, die insbesondere ein Steuergerät zur Steuerung eines Systems oder Subsystems an Bord eines Kraftfahrzeugs umfass en kann. Zur Herstellung einer elektrischen Verbindung zwischen der elektronischen Schaltung und weiteren Komponenten ist ein Steckverbinder vorgesehen, der üblicher Weise eine Vielzahl Steckkontakte umfasst. Um die elektronische Schaltung gegen Staub und Feuchtigkeit zu schützen, kann der Steckverbinder mittels einer aushärtenden Dichtmasse gegenüber dem Modulgehäuse abgedichtet sein.

Während der Herstellung des Modulgehäuses können Fertigungsschritte erforderlich sein, bei denen der Steckverbinder bezüglich des Modulgehäuses mechanisch belastet wird. Unter Umständen ist während dieser Fertigungsschritte die Dichtmasse zwischen dem Steckverbinder und dem Modulgehäuse noch nicht aufgebracht oder noch nicht ausgehärtet. Beispielsweise kann nach der Montage des Modulgehäuses eine Dichtheitsprüfung erfolgen, bei der der Steckverbinder in ein korrespondierendes Aufnahmeelement eingesteckt ist. Es kann auch eine abschließende Programmierung der elektronischen Schaltung erfolgen, bei der Steckkontakte des Steckverbinders mit einer Programmiereinrichtung verbunden sind.

Beim Ein- und Ausstecken können mechanische Kräfte auf den Steckverbinder wirken, die eine korrekte Ausrichtung des Steckverbinders bezüglich des Modulgehäuses bzw. der elektronischen Schaltung beeinträchtigen. Insbesondere kann der Steckverbinder bezüglich des Modulgehäuses bzw. der elektronischen Schaltung verkippt werden. Dadurch kann eine mechanische Belastung von elektrischen Verbindungsstellen zwischen den Steckverbinder und der elektronischen Schaltung entstehen, die zu einem Ausfall des Steuergeräts zu einem späteren Zeitpunkt führen können. Außerdem können die Dichtheit des Modulgehäuses und die Montierbarkeit der Baugruppe beeinträchtigt sein.

Es ist daher Aufgabe der Erfindung, ein Modulgehäuse bereitzustellen, dass eine verbesserte mechanische Fixierung des Steckverbinders bereitstellt. Die Erfindung löst diese Aufgabe mittels eines Modulgehäuses mit den Merkmalen des unabhängigen Anspruchs. Unteransprüche geben bevorzugte Ausführungsformen wieder.

Ein erfindungsgemäßes Modulgehäuse weist ein Gehäusebauteil und einen Steckverbinder auf. Das Gehäusebauteil ist insbesondere zur Befestigung einer elektronischen Baugruppe ausgebildet. Der Steckverbinder ist insbesondere zur elektrischen Verbindung mit der Baugruppe ausgebildet. Der Steckverbinder weist eine Vielzahl Aufnahmen für elektrische Steckkontakte und einen die Aufnahmen umlaufenden Steckrahmen auf.

Zweckmäßigerweise hat der Steckverbinder einen Grundkörper, welcher die Aufnahmen enthält und den Steckrahmen aufweist. Beispielsweise sind die Aufnahmen in einer Grundplatte des Grundkörpers ausgebildet, insbesondere durchdringen sie die Grundplatte in einer Steckrichtung. Der Steckrahmen erstreckt sich beispielsweise entgegen der Steckrichtung von einem Ende, das mit der Grundplatte verbunden ist zu einer Öffnung an einer von der Grundplatte abgewandten Seite des Steckrahmens.

Das Modulgehäuse weist zur mechanischen Befestigung des Steckverbinders am Gehäusebauteil eine Arretierungsanordnung auf. Die Arretierungsanordnung ist insbesondere dazu vorgesehen, das Gehäusebauteil und den Steckverbinder zueinander auszurichten.

Die Arretierungsanordnung weist ein Arretierungselement des Steckverbinders und ein Arretierungselement des Gehäusebauteils auf. Das Arretierungselement des Steckverbinders weist ein Hakenelement auf. Das Arretierungselement des Gehäusebauteils weist eine korrespondierende Aussparung zur Aufnahme des Hakenelements auf. Der Begriff "Hakenelement" beinhaltet dabei keine Beschränkung auf eine besondere Formgebung des Hakenelements, insbesondere keine Beschränkung auf eine gebogene oder gewinkelte Form. Vielmehr ist das Hakenelement dazu ausgebildet, sich mit der korrespondierenden Aussparung zur Arretierung des Steckverbinders mit dem Gehäusebauteil "zu verhaken", d.h. insbesondere eine formschlüssige Verbindung einzugehen.

Bei einer Ausführungsform erstreckt sich das Arretierungselement des Steckverbinders parallel zu einer Erstreckungsrichtung des Steckrahmens. Das Hakenelement kann an einem Ende des Arretierungselements des Steckverbinders angeordnet sein und sich rechtwinklig vom Arretierungselement erstrecken.

Bei einer Ausführungsform ist das Hakenelement von einem Vorsprung eines Endabschnitts des Grundkörpers gebildet. Der Endabschnitt erstreckt sich vorzugsweise ausgehend von der Grundplatte in der Steckrichtung des Steckverbinders. Beispielsweise bildet die Grundplatte mit zwei in einer Querrichtung gegenüberliegenden Endabschnitten eine U-Form, die insbesondere in Steckrichtung geöffnet ist. Der Vorsprung ragt vorzugweise in einer Fügerichtung zu dem Arretierungselement des Gehäusebauteils hin. Die Fügerichtung ist dabei insbesondere diejenige Richtung, in der der Steckverbinder und das Gehäusebauteil bei der Montage des Modulgehäuses einander angenähert und/oder zusammengesetzt werden.

Bei einer Weiterbildung entspricht die Gestalt der Aussparung der Gestalt des Vorsprungs. Die Aussparung und der Vorsprung sind zweckmäßigerweise derart angeordnet, dass der Vorsprung in die Aussparung eingreift, wobei der Vorsprung bevorzugt die Aussparung vollständig ausfüllt.

In einer Ausführungsform umfasst das Modulgehäuse ferner einen Gehäuseabschluss, um das Modulgehäuse zusammen mit dem Gehäusebauteil und dem Steckverbinder allseits abzuschließen. Der Gehäuseabschluss, der Steckverbinder und das Gehäusebauteil folgen in der Fügerichtung insbesondere in dieser Reihenfolge aufeinander. Mittels des Gehäuseabschlusses kann das Modulgehäuse hermetisch verschließbar sein, isnbesondere mit Hilfe einer Dichtmasse und den jeweiligen Verbindungsstellen zwischen Gehäuseabschluss, Steckverbinder und Gehäusebauteil.

Bei einer Ausführungsform sind das Hakenelement und die korrespondierende Aussparung an einem bezüglich einer Fügerichtung dem Gehäuseabschluss zugewandten Ende des Gehäusebauteils bzw. des Steckverbinders angeordnet und erstrecken sich insbesondere in Fügerichtung höchstens bis zur Mitte des Gehäusebauteils bzw. des Steckverbinders hin.

Das Gehäusemodul gemäß der vorliegenden Offenbarung erlaubt eine Fixierung des Steckverbinders bezüglich des Gehäusebauteils, die ein Verkippen oder Verschwenken des Steckverbinders weitgehend verhindern kann. Sowohl das Gehäusebauteil als auch der Steckverbinder können leicht herstellbar sein, beispielsweise im Guss- oder Spritzgussverfahren, ohne eine zusätzliche Hinterschneidung zu erfordern. Die verbesserte Zentrierung des Steckverbinders bezüglich des Gehäusebauteils kann dazu beitragen, dass auch bei einer mechanischen Beanspruchung, wie sie beispielsweise bei Ein- und Aussteckvorgängen des Steckverbinders auftreten kann, die Dichtheit und die Spannungsfreiheit der Elemente, insbesondere des Steckverbinders, erhalten bleiben.

In einer bevorzugten Ausführungsform sind zwei Arretierungselemente an einander gegenüberliegenden Begrenzungen des Steckverbinders angeordnet. Beispielsweise hat der Grundkörper zwei Endabschnitte, die an einander in einer Querrichtung gegenüberliegenden Enden der Grundplatte angeordnet sind. Die Querrichtung ist dabei senkrecht zur Steckrichtung und insbesondere auch senkrecht zur Fügerichtung. Vorzugsweise hat jeder der Endabschnitte ein von der Arretierungsanordnung umfasstes Arretierungselement mit jeweils einem Hakenelement. Das Verkippen des Steckverbinders bezüglich des Gehäusebauteils kann so in verbesserter Weise bezüglich positiven und negativen Kräften verhindert sein. Alternativ oder zusätzlich ist die Gefahr besonders gering, dass der Steckverbinder um eine zur Fügerichtung parallele Achse unbeabsichtigt gedreht wird.

In einer Ausführungsform weist der Steckrahmen eine Breite auf, die um ein Mehrfaches größer als seine Höhe ist. Die Breite ist dabei insbesondere die Ausdehnung in Querrichtung und die Höhe ist die Ausdehnung in Fügerichtung. Bei einer Weiterbildung sind die Arretierungselemente im Bereich von sich entlang der Höhe erstreckenden Abschnitten des Steckrahmens angeordnet. Dadurch kann eine Hebelwirkung ausgenutzt werden, die eine besonders gute Fixierung des Steckverbinders bezüglich des Gehäusebauteils sicher stellen kann.

Der Steckverbinder kann an einem Abschnitt des Steckrahmens, der sich entlang der Breite erstreckt, eine Vertiefung aufweisen, die sich entgegen der Fügerichtung in den Steckverbinder hinein erstreckt. Das Gehäusebauteil hat dann zweckmäßigerweise ein korrespondierendes Arretierungselement zum Eingriff in diese Vertiefung. Dadurch kann insbesondere ein Deformieren des Steckverbinders beim Einstecken oder Ausstecken aus einem korrespondierenden Steckverbinder reduziert sein, und zwar insbesondere in einem von der Arretierungsanordnung nicht unmittelbar fixierten Mittelbereich. Ein- und Aussteckvorgänge, insbesondere während eines Herstellungsprozesses, können so die korrekte Positionierung und die Spannungsfreiheit des Steckverbinders bezüglich mit ihm verbundenen Komponenten nicht beeinflussen.

In einer weiteren bevorzugten Ausführungsform ist der Steckverbinder dazu eingerichtet, in Fügerichtung - das ist insbesondere in Richtung der Hakenelemente - an das Gehäuseelement angenähert zu werden und der Gehäuseabschluss ist dazu eingerichtet, in der gleichen Richtung an das Gehäusebauteil und den Steckverbinder angenähert und mit dem Gehäusebauteil verbunden zu werden, um den Steckverbinder zwischen dem Gehäusebauteil und dem Gehäuseabschluss zu arretieren.

Dadurch kann verhindert werden, dass das Arretierungselement des Steckverbinders unter mechanischer Belastung des Modulgehäuses aus der korrespondierenden Aussparung im Gehäusebauteil herausrutscht und so die Fixierung des Steckverbinders bezüglich des Gehäusebauteils beeinträchtigt.

Ein exemplarisches Ausführungsbeispiel der Erfindung wird nun mit Bezug auf die beigefügten Figuren genauer beschrieben. Es zeigt:
- Figur 1 eine Explosionsdarstellung eines Modulgehäuses gemäß dem exemplarischen Ausführungsbeispiel;
- Figur 2 eine Seitenansicht des Modulgehäuses von Figur 1;
- Figur 3 eine perspektivische Ansicht des Gehäusebauteils des Modulgehäuses von Figur 1;
- Figur 4 eine perspektivische Ansicht des Steckverbinders des Modulgehäuses von Figur 1,
- Figur 5 eine weitere perspektivische Ansicht des Gehäusebauteils des Modulgehäuses von Figur 1
- Figur 6 eine schematische Seitenansicht des Steckverbinders des Modulgehäuses von Figur 1.

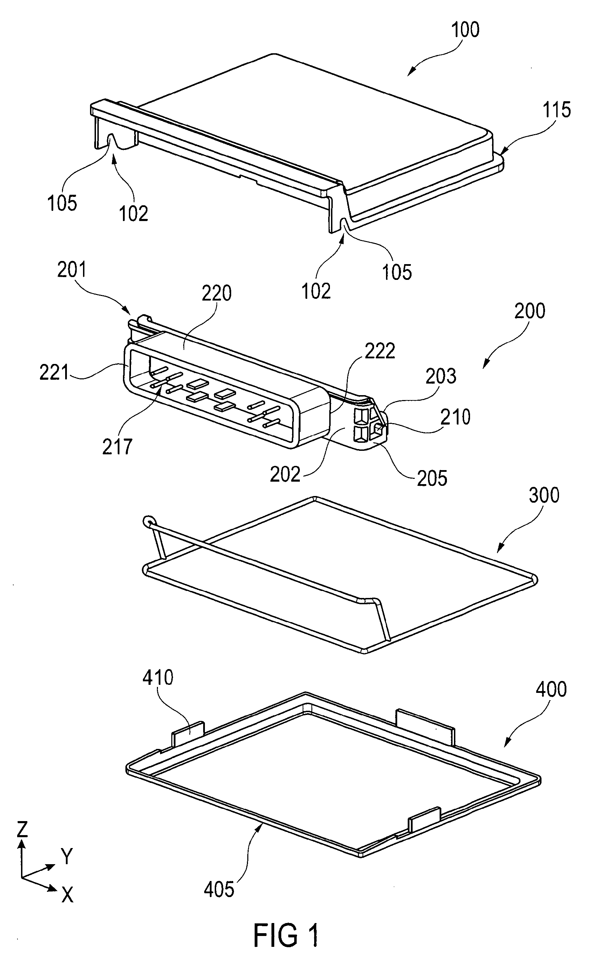

Figur 1 zeigt ein Modulgehäuse in einer Explosionsdarstellung. Das dargestellte Modulgehäuse weist ein Gehäusebauteil 100, einen Steckverbinder 200, eine optionale Dichtmasse 300 und einen Gehäuseabschluss 400 auf. Das Gehäusebauteil 100, der Steckverbinder 200 und der Gehäuseabschluss 400, der auch als weiteres Gehäusebauteil bezeichnet werden kann, umschließen einen Innenraum des Modulgehäuses.

In Figur 1 ist ferner ein kartesisches Koordinatensystem mit x-, y- und z-Richtung angegeben. In dieser und den folgenden Figuren wird Gebrauch von dieser exemplarischen, nicht als einschränkend zu verstehenden Definition gemacht.

Das Gehäusebauteil 100 ist bevorzugter Weise im Guss- oder Spritzgussverfahren herstellbar. Beispielsweise besteht das Gehäusebauteil 100 aus einem Metall. Üblicherweise ist das Gehäusebauteil 100 so geformt, dass eine elektronische Baugruppe, die insbesondere eine Platine aufweisen kann, von wenigstens einer Seite mittels des Gehäusebauteils 100 abgedeckt werden kann. In der Darstellung von Figur 1 ist das Gehäusebauteil 100 dazu eingerichtet, die elektronische Baugruppe in vier Richtungen abzudecken, nämlich in positiver z-Richtung, in positiver y-Richtung sowie in positiver und negativer x-Richtung.

Der Steckverbinder 200 hat einen Grundkörper 201, der bevorzugter Weise ebenfalls im Guss- oder Spritzgussverfahren herstellbar und so geformt ist, dass er mit dem Gehäusebauteil 100 in Anlage bzw. Eingriff gebracht werden kann. Der Grundkörper 201 des Steckverbinders 200 ist beispielsweise aus einem Kunststoffmaterial hergestellt. Der Steckverbinder 200 kann am Gehäusebauteil 100 angebracht werden, indem,er in der gezeigten Position in positiver z-Richtung auf das Gehäusebauteil 100 zu bewegt wird.

Der Grundkörper 201 des Steckverbinders 200 weist eine Vielzahl Aufnahmen 215 auf, die jeweils zur Aufnahme eines elektrischen Steckkontakts 217 des Steckverbinders 200 vorgesehen sind. Jeder der elektrischen Steckkontakte 217 kann männlich oder weiblich sein oder ein weiteres Steckelement wie eine Abschirmung umfassen. In der dargestellten, bevorzugten Ausführungsform weist der Grundkörper einen Steckrahmen 220 auf, der umlaufend um die Aufnahmen 215 bzw. die Steckkontakte 217 ausgebildet ist.

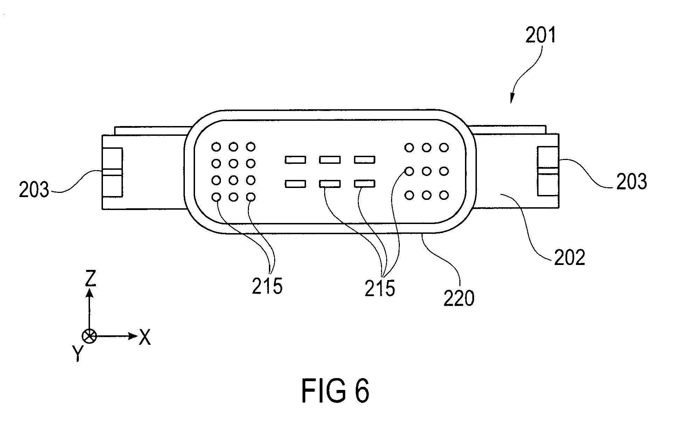

Der Steckrahmen 220 erstreckt sich in negativer y-Richtung, in der auch die Aufnahmen 215 oder die in ihnen aufgenommenen Steckkontakte 217 verlaufen. Die Aufnahmen 215 bzw. die Steckkontakte 217 sind durch den Steckrahmen 220 also in positiver und negativer x-Richtung sowie in positiver und negativer z-Richtung abgedeckt. Beispielsweise sind die Aufnahmen 215 in einer Grundplatte 202 des Grundkörpers 201 enthalten und der Steckrahmen 220 verläuft in Draufsicht auf eine Haupterstreckungsebene der Grundplatte 202 um die Aufnahmen 215 bzw. die Steckkontakte 217 herum (siehe Figur 6). Der Steckrahmen 220 erstreckt sich bevorzugt von einem mit der Grundplatte verbundenen Ende 222 zu einer von der Grundplatte 202 abgewandten Öffnung 201, so dass er eine Steckrichtung definiert, die insbesondere parallel zu einer Normalen auf die Haupterstreckungsebene der Grundplatte ist. Vorliegend fällt die Steckrichtung mit der (positiven) y-Richtung zusammen. Die Grundplatte 202 und der Steckrahmen 220 sind vorzugsweise Abschnitte eines einstückig ausgeführten Grundkörpers 201.

Der Steckrahmen 220 ist insbesondere dazu eingerichtet, in eine entsprechende Aufnahme eines Gegensteckers oder einer Buchse einzugreifen, die elektrisch und mechanisch mit dem Steckverbinder 200 verbindbar ist. Zur Verbindung ist der Gegenstecker bzw. die Buchse insbesondere in Steckrichtung auf den Steckrahmen 220 steckbar. In einer Ausführungsform umfasst der Steckrahmen 220 einen oder mehrere Teilungsstege, die entlang der z-Richtung verlaufen. Es können auch mehrere, voneinander separate Steckrahmen 220 vorgesehen sein.

Der Steckverbinder 200 erstreckt sich über die gesamte Breite des Gehäusebauteils 100. Insbesondere ragt die Grundplatte 202 des Grundkörpers 201 des Steckverbinders 200 in einer Querrichtung - die vorliegend der x-Richtung entspricht - beidseitig über den Steckrahmen 220 hinaus. Der Grundkörper 201 weist Endabschnitte 203 auf, die sich in Querrichtung an die Grundplatte 202 anschließen und in einem Winkel - insbesondere senkrecht - zu der Querrichtung in Steckrichtung von dem Steckrahmen 220 weg erstrecken. In Draufsicht auf die von Quer- und Steckrichtung gebildete Ebene bilden die Endabschnitte 203 zusammen mit der Grundplatte 202 eine U-Form, die insbesondere in Steckrichtung geöffnet ist.

Der Gehäuseabschluss 400 schließt das dargestellte Modulgehäuse in negativer z-Richtung ab. In einer Ausführungsform ist der Gehäuseabschluss 400 aus einem Metallblech hergestellt, beispielsweise durch Prägen, Pressen oder Tiefziehen. In positiver z-Richtung liegende Oberflächen des Gehäuseabschlusses 400 sind dazu eingerichtet, an korrespondierenden Oberflächen in negativer z-Richtung des Gehäusebauteils 100 und des Steckverbinders 200 anzuliegen. Dabei kann die Dichtmasse 300 zwischen den Gehäuseabschluss 400 und den anderen Komponenten 100, 200 vorgesehen sein.

In der dargestellten Ausführungsform umfasst der Gehäuseabschluss 400 einen sich in positiver z-Richtung erstreckenden, umlaufenden Rand 405. Der Rand 405 ist dazu eingerichtet, nach der Anbringung des Gehäuseabschlusses 400am Gehäusebauteil 100 in der x-y-Ebene an diesem anzuliegen. Biegelaschen 410, die am Gehäuseabschluss 400 ausgeformt sind, können um den Bund 115 des Gehäusebauteils 100 umgebogen werden, um den Gehäuseabschluss 400 am Gehäusebauteil 100 zu fixieren.

Der Rand 405 kann in einer anderen Ausführungsform in einen entsprechenden Absatz oder eine entsprechende Nut am Gehäusebauteil 100 eingreifen. In ähnlicher Weise kann der Rand 405 auch am Steckverbinder 200 anliegen bzw. in diesen eingreifen. Dazu kann auch der Steckverbinder 200 ebenfalls einen Absatz oder eine Nut aufweisen. Der Gehäuseabschluss 400 kann mittels des Rands 405 eine Klammerwirkung auf das Gehäusebauteil 100 und den Steckverbinder 200 ausüben, sodass der Steckverbinder 200 nach der Montage an den Komponenten 100 und 400 durch den Rand 405 an einer Entfernung vom Gehäusebauteil 100 in negativer y-Richtung gehindert ist. Anders ausgedrückt kann der Rand 405 das Gehäusebauteil 100 und den Steckverbinder 200 derart umgreifen, dass er eine Verschiebung des Steckverbinders 200 entgegen der Steckrichtung relativ zum Gehäuseabschluss 400 begrenzt.

Der Gehäuseabschluss 400, der Steckverbinder 200 und das Gehäusebauteil 100 sind in einer Fügerichtung zusammengesetzt. Die Fügerichtung entspricht vorliegend der (positiven) z-Richtung. Beispielsweise wird zur Montage des Modulgehäuses der Steckverbinder 200 in der Fügerichtung dem Gehäusebauteil 100 angenähert und auf dieses aufgesetzt. Nachfolgend wird beispielsweise der Gehäuseabschluss 400 in Fügerichtung dem Steckverbinder 200 und dem Gehäusebauteil 100 angenähert und auf diese aufgesetzt. Die Fügerichtung ist vorzugsweise senkrecht zur Steckrichtung und zur Querrichtung. Die Steckrichtung und die Querrichtung spannen vorzugsweise eine Haupterstreckungsebene des Modulgehäuses auf, auf der die Fügerichtung senkrecht steht.

In der dargestellten, bevorzugten Ausführungsform ist die Dichtmasse 300 dazu vorgesehen, das Gehäusebauteil 100, den Steckverbinder 200 und den Gehäuseabschluss 400 gegeneinander abzudichten. Bevorzugter Weise handelt es sich um eine aushärtende Dichtmasse, welche die Komponenten 100, 200 und 400 mechanisch aneinander befestigt. Bei einer Ausgestaltung ist auf eine zusätzliche mechanische Fixierung, beispielsweise durch Schrauben, Nieten oder Rastverschlüsse verzichtet.

Im Bereich einer Begrenzung in negativer y-Richtung ist das Gehäusebauteil 100 zur Anlage bzw. zum Eingriff mit dem Steckverbinder 200 geformt. Dazu tragen in diesem Bereich die Begrenzungen in positive und negative x-Richtung jeweils eine Aussparung 105, die in positiver z-Richtung verläuft, sodass offene Enden der Aussparung 105 in negative z-Richtung weisen. Im Bereich von Begrenzungen in positiver und negativer x-Richtung weist der Steckverbinder 200 jeweils ein Arretierungselement 205 auf. Das Arretierungselement 205 erstreckt sich in positiver y-Richtung und umfasst an seinem Ende ein Hakenelement 210, dass dazu eingerichtet ist, in positiver z-Richtung in eine der Aussparungen 105 des Gehäusebauteils 100 einzugreifen. Der Eingriff erfolgt vorzugsweise formschlüssig, sodass kein Zwischenraum zwischen dem Steckverbinder 200 und dem Gehäusebauteil 100 verbleibt. In ähnlicher Weise liegt die Begrenzung des Steckverbinders 200 in positiver z-Richtung möglichst spaltfrei an einer Begrenzung des Gehäusebauteils 100 in negativer z-Richtung an.

Anders ausgedrückt weist das Modulgehäuse eine Arretierungsanordnung auf, die dazu eingerichtet ist, das Gehäusebauteil 100 und den Steckverbinder 200 zueinander auszurichten. Die Arretierungsanordnung weist ein Arretierungselement 102 des Gehäusebauteils 100 und ein korrespondierendes Arretierungselement 205 des Steckverbinders 200 auf. Das Arretierungselement 102 des Gehäusebauteils 100 ist beispielsweise an einem dem Steckverbinder 200 zugewandten Endabschnitt einer längsseitigen - d.h. insbesondere von dem Steckverbinder 200 zu einem dem Steckverbinder 200 gegenüber liegenden Ende des Gehäusebauteils 100 verlaufenden - Seitenwand des Gehäusebauteils 100 ausgebildet. Das Arretierungselement 205 des Steckverbinders ist beispielsweise an einem der Endabschnitte 203 des Grundkörpers 201 des Steckverbinders 200 ausgebildet. Vorliegend und bevorzugt weist die Arretierungsanordnung zwei Arretierungselemente 102 des Steckverbinders 200 auf, die an den beiden bezüglich der Querrichtung gegenüberliegenden Endabschnitten 203 des Grundkörpers 201 ausgebildet sind, und zu zwei Arretierungselementen 102 des Gehäusebauteils 100 korrespondieren, welche an bezüglich der Querrichtung gegenüberliegenden längsseitigen Seitenwänden des Gehäusebauteils 100 ausgebildet sind.

Das Arretierungselement 205 - bzw. jedes der Arretierungselemente 205 - des Steckverbinders 200 weist ein Hakenelement 210 auf. Das Hakenelement 210 ist beispielsweise ein Vorsprung, insbesondere eine Nase, des jeweiligen Endabschnitts 203 des Grundkörpers 201 des Steckverbinders 200. Der Vorsprung 210 ragt in der Fügerichtung zu dem korrespondierenden Arretierungselement 102 des Gehäusebauteils 100 hin.

Das korrespondierende Arretierungselement 102 hat eine Aussparung 105, deren Gestalt der Gestalt des Vorsprungs 210 entspricht. Insbesondere ist die Aussparung 105 entgegen der Fügerichtung geöffnet. Die Aussparung 105 und der Vorsprung 210 sind derart angeordnet, dass bei dem zusammengesetzten Modulgehäuse der Vorsprung 210 in die Aussparung 105 eingreift. Vorzugsweise füllt der Vorsprung 210 die Aussparung 105 vollständig aus.

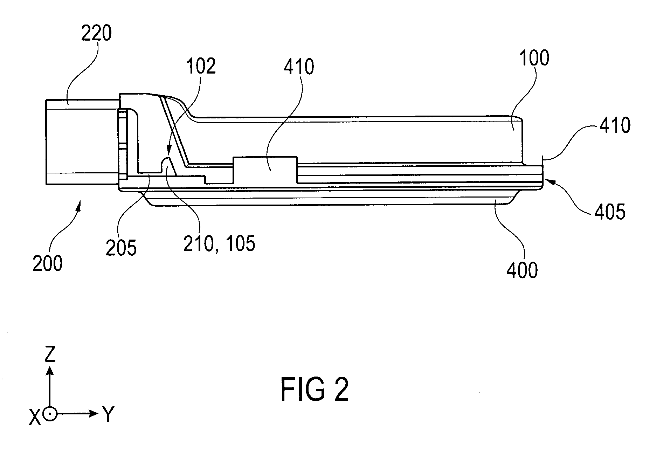

Figur 2 zeigt eine Seitenansicht des Modulgehäuses von Figur 1. Die x-Achse ist auf den Betrachter zu gerichtet. Die Darstellung zeigt das Modulgehäuse von Figur 1 in einem zusammengebauten Zustand, wobei die Dichtmasse 300 nicht erkennbar ist.

Es ist erkennbar, wie das Hakenelement 210 des Arretierungselements 205 in positiver z-Richtung in die Aussparung 105 am Gehäusebauteil 100 eingreift.

Das Hakenelement 210 und die korrespondierende Aussparung 105 sind an einem bezüglich der Fügerichtung dem Gehäuseabschluss 400 zugewandten Ende des Gehäusebauteils 100 bzw. des Steckverbinders 200 angeordnet. Insbesondere erstrecken sie sich in Fügerichtung nicht über die Mitte des Gehäusebauteils 100 bzw. des Steckverbinders 200 hinaus. Auf diese Weise ist die Gefahr besonders gering, dass der Steckverbinder 200 bei mechanischer Belastung unbeabsichtigt um eine zur Querrichtung parallele Drehachse kippt, z.B. beim Ein- oder Ausstecken des Gegensteckers bzw. der Buchse. Insbesondere wird ein Verkippen des Steckverbinders 200 um eine Drehachse, die beispielsweise parallel zur x-Achse verläuft, durch die Anlageflächen zwischen dem Steckverbinder 200 und dem Gehäusebauteil 100 verhindert. Dabei kann die Länge des Arretierungselements 205 in positiver x-Richtung als Abstützhebel wirken.

Ebenfalls erkennbar ist, wie der Rand 405 des Gehäuseabschlusses 400 den Steckverbinder 200 mit dem Gehäusebauteil 100 in der x-y-Ebene zusammenklammert. Die Biegelaschen 410 sind in der Darstellung von Figur 2 noch nicht ungebogen.

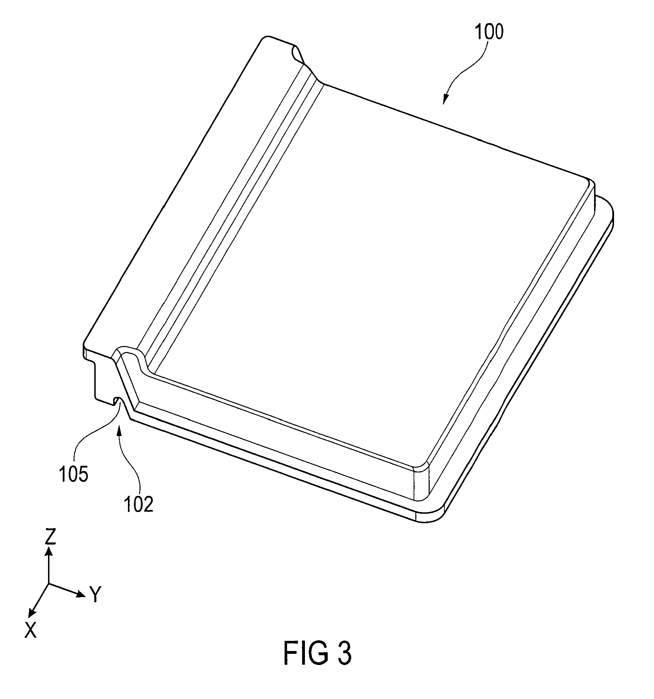

Figur 3 zeigt eine weitere Ansicht des Gehäusebauteils 100 des Modulgehäuses von Figur 1. In der dargestellten Perspektive ist insbesondere eine der Aussparungen 105 deutlicher als in Fig. 1 zu erkennen.

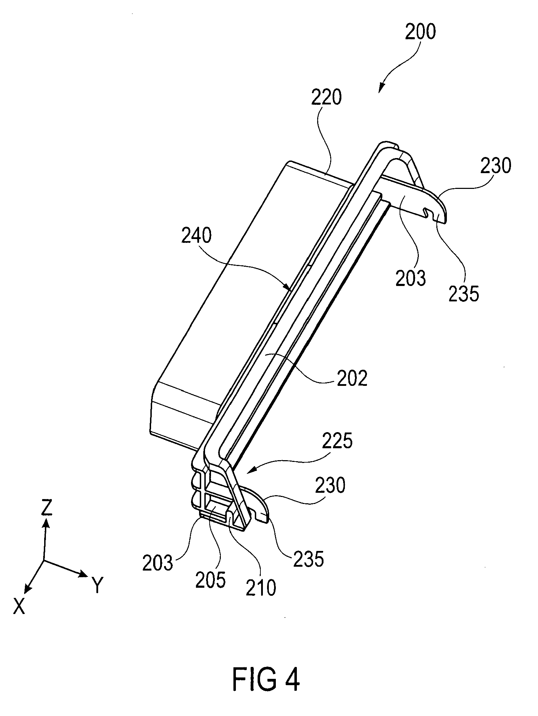

Figur 4 zeigt eine weitere Ansicht des Steckverbinders 200 des Modulgehäuses von Figur 1. Dabei entspricht die Perspektive in etwa der von Figur 3. An dem dem Betrachter zugewandten Arretierungselement 205 ist zu erkennen, dass das Arretierungselement 205 und das Hakenelement 210 in negativer x-Richtung an einer Stützstruktur 225 befestigt sind, sodass insbesondere ein in positiver y-Richtung verlaufende Abschnitt des Arretierungselements 205 gegen Verbiegen geschützt ist. Die Stützstruktur 225 ist einstückig am Steckverbinder 200 ausgeformt und Bestandteil des jeweiligen Endabschnitts 203 des Grundkörpers 201. Die Stützstruktur 225 weist eine in der z-y-Ebene liegende Wand auf, von der aus sich Rippen in positiver x-Richtung erstrecken. Zwei der Rippen verlaufen in der x-y-Ebene, eine weitere senkrecht dazu in der x-z-Ebene.

An der Wand der Stützstruktur 225 ist optional ein Halteelement 230 ausgeformt, das sich in der z-y-Ebene erstreckt. Dabei ist das Halteelement 230 dazu eingerichtet, in positiver x-Richtung an einer Innenseite des Gehäusebauteils 100 anzuliegen, wenn der Steckverbinder 200 am Gehäusebauteil 100 angebracht ist, wie beispielsweise in Figur 2 dargestellt ist. In der dargestellten, bevorzugten Ausführungsform weist das Halteelement 230 eine Auflage 235 auf, auf welche die Platine der elektronischen Baugruppe aufgelegt werden kann.

Im Bereich seiner Begrenzung in positiver z-Richtung - mit anderen Worten an seinem in Fügerichtung dem Gehäusebauteil 100 zugewandten und von dem Gehäuseabschluss 400 abgewandten Ende - hat der Grundkörper 201 des Steckverbinders 200 ferner eine Vertiefung 240. Die Vertiefung 240 ist beispielsweise in der Mitte des Steckrahmens 220 bzw. der Grundplatte 202 in Bezug auf die Querrichtung angeordnet. Mittels eines korrespondierend geformten Eingreifelement 110 des Gehäusebauteils 100, das in negativer z-Richtung - d.h. entgegen der Fügerichtung - in die Vertiefung 240 eingeführt ist, wird der Steckverbinder 200 durch mechanische Wechselwirkung des Eingreifelements 100 mit der Vertiefung 240 insbesondere in positiver und negativer y-Richtung gehalten. Dadurch können Kräfte, die auf den Steckverbinder 200 beim Einstecken bzw. Lösen einer Steckverbindung zwischen dem Steckverbinder 200 und einem korrespondierenden Verbinder entstehen können, in das Gehäusebauteil 100 eingeleitet werden. Einem Verbiegen oder Verschieben des Steckverbinders 200 bezüglich des Gehäusebauteils 100 wird dadurch entgegengewirkt. Die Gefahr, dass die Grundplatte 202 in einem Mittelbereich zwischen den bezüglich der Querrichtung gegenüberliegenden Arretierungselementen 102, 205 aus der von der Querrichtung und der Fügerichtung aufgespannten Ebene heraus gebogen wird, wenn sie in oder entgegen der Steckrichtung mechanisch belastet wird, ist auf diese Weise besonders gering.

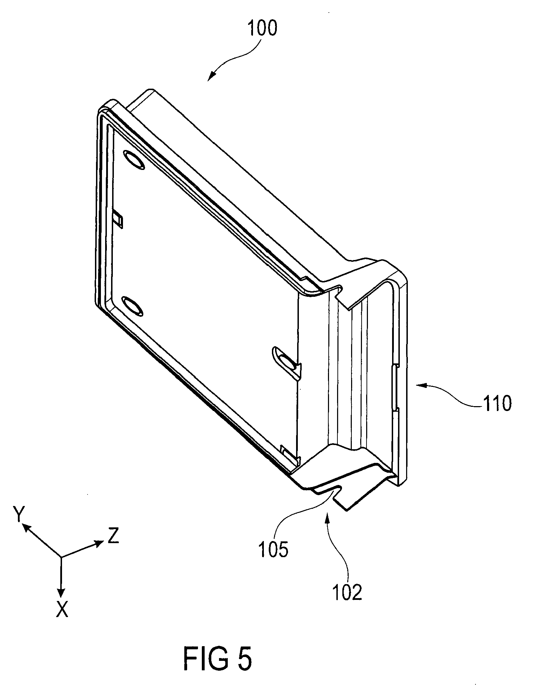

Figur 5 zeigt eine weitere perspektivische Ansicht des Gehäusebauteils 100 des Modulgehäuses aus Figur 1. Hier ist das Eingreifelement 110 am Gehäusebauteil 100 erkennbar, das dazu eingerichtet ist, in die Vertiefung 240 des Steckverbinders 200 einzugreifen. In anderen Ausführungsformen können auch mehrere Eingreifelemente 110 am Gehäusebauteil 100 und mehrere korrespondierende Vertiefungen 240 am Steckverbinder 200 vorgesehen sein.

## Patentansprüche

1. Modulgehäuse mit einem Gehäusebauteil (100) zur Befestigung einer elektronischen Baugruppe und einem Steckverbinder (200) zur elektrischen Verbindung mit der Baugruppe,
wobei der Steckverbinder (200) einen Grundkörper (201) mit einer Vielzahl von Aufnahmen (215) für elektrische Steckkontakte (217) und mit einem die Aufnahmen (215) umlaufenden Steckrahmen (220) aufweist
wobei das Modulgehäuse zur mechanischen Befestigung des Steckverbinders (200) am Gehäusebauteil (100) eine Arretierungsanordnung aufweist, die ein Arretierungselement (205) des Steckverbinders (200) und ein Arretierungselement (102) des Gehäusebauteils (100) aufweist,
wobei das Arretierungselement (205) des Steckverbinders (200) ein Hakenelement (210) und das Arretierungselement (102) des Gehäusebauteils (100) eine korrespondierende Aussparung (105) zur Aufnahme des Hakenelements (210) aufweist.

2. Modulgehäuse nach Anspruch 1,
wobei sich das Arretierungselement (205) des Steckverbinders (200) parallel zu einer Erstreckungsrichtung des Steckrahmens (220) erstreckt;
wobei das Hakenelement (210) an einem Ende des Arretierungselements (205) des Steckverbinders (200) angeordnet ist; und
- sich das Hakenelement (210) rechtwinklig vom Arretierungselement (205) erstreckt.

3. Modulgehäuse nach Anspruch 1,
wobei das Hakenelement (210) von einem Vorsprung eines Endabschnitts (203) des Grundkörpers (201) gebildet ist, wobei sich der Endabschnitt (203) ausgehend von einer die Aufnahmen (215) aufweisenden Grundplatte (202) des Grundkörpers (201) in einer Steckrichtung (y) des Steckverbinders (200) erstreckt und
wobei der Vorsprung (210) in einer Fügerichtung zu dem Arretierungselement (102) des Gehäusebauteils (100) hin ragt.

4. Modulgehäuse nach Anspruch 3, wobei die Gestalt der Aussparung (105) der Gestalt des Vorsprungs (210) entspricht und die Aussparung (105) der Vorsprung (210) derart angeordnet sind, dass der Vorsprung (210) in die Aussparung (105) eingreift.

5. Modulgehäuse gemäß Anspruch 4, wobei der Vorsprung (210) die Aussparung (105) vollständig ausfüllt.

6. Modulgehäuse nach einem der vorhergehenden Ansprüche, wobei der Steckverbinder (200) zwei Arretierungselemente (205) an einander gegenüberliegenden Begrenzungen des Steckverbinders (200) angeordnet sind.

7. Modulgehäuse nach einem der vorangehenden Ansprüche, wobei
- der Steckrahmen (220) eine Breite aufweist, die um ein Mehrfaches größer als seine Höhe ist;
- der Steckverbinder (200) an einem Abschnitt des Steckrahmens (220), der sich entlang der Breite erstreckt, eine Vertiefung (240) aufweist, die sich entgegen einer Fügerichtung des Modulgehäuses in den Steckverbinder (200) hinein erstreckt, und
- das Gehäusebauteil (100) ein korrespondierendes Eingreifelement (110) zum Eingriff in die Vertiefung (240) umfasst.

8. Modulgehäuse nach einem der vorangehenden Ansprüche, ferner umfassend einen Gehäuseabschluss (400), um das Modulgehäuse zusammen mit dem Gehäusebauteil (100) und dem Steckverbinder (200) allseits abzuschließen.

9. Modulgehäuse nach Anspruch 8, wobei das Hakenelement (210) und die korrespondierende Aussparung (105) an einem bezüglich einer Fügerichtung dem Gehäuseabschluss (400) zugewandten Ende des Gehäusebauteils (100) bzw. des Steckverbinders (200) angeordnet sind und sich insbesondere in Fügerichtung höchstens bis zur Mitte des Gehäusebauteils (100) bzw. des Steckverbinders (200) hin erstrecken.

10. Modulgehäuse nach Anspruch 9, wobei der Steckverbinder (200) dazu eingerichtet ist, in Richtung der Hakenelemente (210) an das Gehäusebauteil (100) angenähert zu werden und der Gehäuseabschluss (400) dazu eingerichtet ist, in der gleichen Richtung an das Gehäusebauteil (100) angenähert und mit diesem verbunden zu werden, um den Steckverbinder (200) zwischen dem Gehäusebauteil (100) und dem Gehäuseabschluss (400) zu arretieren.
